# EUROPEAN PATENT APPLICATION

(11) **EP 4 817 810 A1**
(43) Date of publication of application: **07.10.2026**
(21) Application number: 26169445.9
(22) Date of filing: 31.03.2026
(51) Int. Cl.: B25J 9/16, B64G 4/00, G05B 17/00, G06N 3/02

(54) **SYSTEM AND METHOD FOR PERFORMING SIMULATION OF OPERATIONAL TASKS OF A ROBOTIC SYSTEM USING MACHINE LEARNING**

(30) Priority: 31.03.2025 US 202563780914 P
(71) Applicant: MacDonald, Dettwiler and Associates Inc., Brampton, Ontario L6Y 6K7 (CA)
(72) Inventor: EL SAMID, Nader Abu, Brampton, L6Y 6K7 (CA); PANKOV, Taras, Brampton, L6Y 6K7 (CA); AHMAD, Usman, Brampton, L6Y 6K7 (CA)
(74) Representative: Worsley, Theo Morgan

(57) **Abstract**

A computer system for modeling dynamics of a space robotic system is provided. The system includes a simulator module for simulating dynamics of at least one dynamical system, the simulator module including a dynamics engine module and a first machine learning model that operate in a feedback loop, for each timestep in the series of simulation timesteps the simulator module determines (i) position or velocity values of the at least one dynamical system and (ii) force or moment values of the at least one dynamical system, the force or moment values are predicted by the first machine learning model based on the position or velocity values from the same timestep, after the first timestep, the position or velocity values are calculated by the dynamics engine module based on a motion equation, the simulator module determines the position or velocity values and the force or moment values until a last timestep.

## Description

### Technical Field

The following relates generally to robotic systems, and more particularly to systems and methods for simulating operational tasks performed by a robotic system.

### Introduction

Mission-specific analysis on the International Space Station currently requires an analyst to manually set up the dynamic simulations, initial conditions, and boundary conditions, analyze the results, and possibly iterate on the simulation parameters. This process can take weeks, or months, to complete satisfactorily. This analysis step can become a bottleneck in the mission planning workflow. Additionally, existing high fidelity dynamics simulators are too computationally intensive to run on flight, so the analysis has to be performed on the ground.

Accordingly, there is a need for an improved system and method for simulating operational tasks of a robotic system that overcomes at least some of the disadvantages of existing systems and methods.

### Summary

A computer system for modeling dynamics of a space robotic system including a robotic device is provided. The system includes a computer memory and at least one processor in communication with the computer memory, the at least one processor is configured to execute a simulator module for simulating dynamics of at least one dynamical system including the robotic device at a series of simulation timesteps during an operation executed by the robotic device, the simulator module includes a dynamics engine module and a first machine learning model that operate in a feedback loop, for each timestep in the series of simulation timesteps the simulator module determines (i) position or velocity values of the at least one dynamical system and (ii) force or moment values of the at least one dynamical system, for a first timestep a set of initial conditions are provided to the dynamics engine module to calculate the position or velocity values, the force or moment values are predicted by the first machine learning model based on the position or velocity values from the same timestep, after the first timestep, the position or velocity values are calculated by the dynamics engine module based on a motion equation that is updated using the force or moment values from the immediately preceding timestep, and the simulator module determines the position or velocity values and the force or moment values until a last timestep.

In an embodiment, the robotic device may include a robotic arm with an end effector that interfaces with a payload during the operation, the at least one dynamical system may further include the payload, and the simulator module may simulate contact dynamics.

In an embodiment, the simulator module may be implemented on a flight computer that operates onboard the space robotic system when in flight.

In an embodiment, the first machine learning model may include a physics-informed neural network (PINN).

In an embodiment, the simulator module may be configured using input data including dynamics parameters, control parameters, and simulation parameters.

In an embodiment, the simulator module may output results data including time series data of positions, velocities, or contact forces and moments across each timestep of the series of simulation timesteps.

In an embodiment, the results data may be used to generate training data for training a second machine learning model to support the robotic device during operations.

In an embodiment, the second machine learning model may be a virtual sensor used to collect telemetry or other sensor data during performance of tasks by the robotic device or a reinforcement learning model used for planning robotic operations.

In an embodiment, the first machine learning model may include a neural network trained according to a supervised learning process that uses labelled examples including (i) input states including positions and velocities and (ii) expected forces and moments.

In an embodiment, the labelled examples may include a combination of real data and simulated data.

In an embodiment, the simulated data may be generated using a high-fidelity simulator or digital twins.

In an embodiment, the simulator module may be used to test a potential workaround for the robotic device in response to an anomaly detected in telemetry collected during performance of the operation.

In an embodiment, the system may further include an anomaly detector module configured to process telemetry collected during performance of the operation by the robotic device and flag anomalies when patterns in the telemetry deviate from normal, and the simulator module may be invoked to test a workaround for the robotic device in response to the anomaly detector module flagging an anomaly.

In an embodiment, the system may further include a reinforcement learning module configured to generate the workaround that is tested by the simulator module.

In an embodiment, the simulator module may be used to test a script to be executed by the robotic device during the operation prior to the script being incorporated into a flight product and uploaded to the robotic device.

In an embodiment, the motion equation may include equations from classical mechanics or Hamiltonian mechanics that predict how forces and torques cause changes in position, velocity, or acceleration over time.

In an embodiment, the motion equation may include classical or modern dynamic equations.

In an embodiment, the motion equation may include Euler-Lagrange and Newton-Euler.

In an embodiment, the set of initial conditions may include initial positions, velocities, and control inputs of the at least one dynamical system.

In an embodiment, the last timestep may occur after a predefined number of timesteps have occurred.

In an embodiment, the last timestep may occur after a stopping criterion is met.

In an embodiment, the results data may include a final state or stability metrics at the last timestep.

In an embodiment, the final state may include an overall configuration of the at least one dynamical system including kinematic or dynamic parameters fully describing the at least one dynamical system.

In an embodiment, the final state may include joint angles, linear velocities, and rotational velocities.

In an embodiment, the position or velocity values include position values and velocity values.

In an embodiment, the force or moment values include force values and moment values.

A method of simulating dynamics of a space robotic system is also provided. The method includes configuring a simulator module to run a simulation that simulates dynamics of at least one dynamical system in the space robotic system at a series of simulation timesteps during an operation executed by the space robotic system, the simulator module including a dynamics engine module and a first machine learning model, executing the simulation using the simulator module, the simulator module implementing a feedback loop in which the first machine learning model predicts force or moment values on the at least one dynamical system for a current timestep in the series of simulation timesteps using position or velocity values calculated by the dynamics engine for the current timestep as input and the dynamics engine calculates position or velocity values of the at least one dynamical system for the current timestep using a motion equation that is updated using force or moment values that were predicted by the first machine learning model for the previous timestep.

In an embodiment, the method may further include using results outputted by the simulator to generate training data for training a second machine learning model for supporting operations of the robotic system and training the machine learning model with the training data.

In an embodiment, the at least one dynamical system may include a payload on which the robotic device acts, the operation may be a contact operation between the robotic device and the payload.

In an embodiment, the simulator module may simulate contact dynamics between the robotic device and a payload.

In an embodiment, the simulator module may simulate flexible body dynamics of the robotic device.

In an embodiment, the at least one dynamical system may include a robotic device and a payload on which the robotic device acts, the operation may be a contact operation between the robotic device and the payload.

In an embodiment, the simulator module may simulate contact dynamics between a first dynamical system and a second dynamical system.

In an embodiment, the simulator module may simulate flexible body dynamics of the at least one dynamical system.

In an embodiment, the first machine learning model may be a neural network module.

In an embodiment, the first machine learning model may be a neural network module.

In an embodiment, the position or velocity values include position values and velocity values.

In an embodiment, the force or moment values include force values and moment values.

Other aspects and features will become apparent, to those ordinarily skilled in the art, upon review of the following description of some exemplary embodiments.

### Brief Description of the Drawings

The drawings included herewith are for illustrating various examples of articles, methods, and apparatuses of the present specification. In the drawings:
Figure 1 is a schematic diagram of a space robotic system, according to an embodiment;
Figure 2 is a block diagram of a computer system for simulating operational tasks of the robotic system of Figure 1, according to an embodiment;
Figure 3 is a schematic diagram of the space robotic system of Figure 1 configured to perform simulation in response to detected anomalies, according to an embodiment;
Figure 4 is a block diagram of a computer system for simulating operational tasks of the robotic system of Figure 3, according to an embodiment;
Figure 5 is a flow diagram of a method of performing simulation of robotic operations, according to an embodiment;
Figure 6 is a flow diagram of a method of performing simulation of robotic operations, according to an embodiment; and
Figure 7 is a flow diagram of a method of performing simulation of robotic operations, according to an embodiment.

### Detailed Description

Various apparatuses or processes will be described below to provide an example of each claimed embodiment. No embodiment described below limits any claimed embodiment and any claimed embodiment may cover processes or apparatuses that differ from those described below. The claimed embodiments are not limited to apparatuses or processes having all of the features of any one apparatus or process described below or to features common to multiple or all of the apparatuses described below.

One or more systems described herein may be implemented in computer programs executing on programmable computers, each comprising at least one processor, a data storage system (including volatile and non-volatile memory and/or storage elements), at least one input device, and at least one output device. For example, and without limitation, the programmable computer may be a programmable logic unit, a mainframe computer, server, and personal computer, cloud-based program or system, laptop, personal data assistance, cellular telephone, smartphone, or tablet device.

Each program is preferably implemented in a high-level procedural or object-oriented programming and/or scripting language to communicate with a computer system. However, the programs can be implemented in assembly or machine language, if desired. In any case, the language may be a compiled or interpreted language. Each such computer program is preferably stored on a storage media or a device readable by a general or special purpose programmable computer for configuring and operating the computer when the storage media or device is read by the computer to perform the procedures described herein.

A description of an embodiment with several components in communication with each other does not imply that all such components are required. On the contrary, a variety of optional components are described to illustrate the wide variety of possible embodiments of the present invention.

Further, although process steps, method steps, algorithms or the like may be described (in the disclosure and / or in the claims) in a sequential order, such processes, methods and algorithms may be configured to work in alternate orders. In other words, any sequence or order of steps that may be described does not necessarily indicate a requirement that the steps be performed in that order. The steps of processes described herein may be performed in any order that is practical. Further, some steps may be performed simultaneously.

When a single device or article is described herein, it will be readily apparent that more than one device / article (whether or not they cooperate) may be used in place of a single device / article. Similarly, where more than one device or article is described herein (whether or not they cooperate), it will be readily apparent that a single device / article may be used in place of the more than one device or article.

As used herein, the term "or" is intended to be inclusive unless expressly indicated otherwise or unless the context clearly dictates otherwise. Thus, the expression "A or B" includes A alone, B alone, and A and B together. The term "and/or" likewise includes any and all combinations of the associated listed items.

References herein to "forces and moments" or to "force and moment data" are intended to include embodiments utilizing force data alone, moment data alone, or both force and moment data, unless the context clearly indicates otherwise.

References herein to "positions and velocities" or to "position and velocity data" are intended to include embodiments utilizing position data alone, velocity data alone, or both position and velocity data, unless the context clearly indicates otherwise.

The following relates generally to robotic systems, and more particularly to simulating operational tasks performed by a robotic system using machine learning.

The systems and methods of the present disclosure use artificial intelligence or machine learning to accelerate pre-flight analysis by using a neural network trained on past flight and/or simulation data to predict simulation results as an alternative to running dynamic simulations in a high fidelity simulator. The systems and methods may also be employed as a lightweight simulator on flight for performing rapid analysis in situ, which may obviate the need for ground intervention when an operational scenario arises that requires analysis. This may be particularly advantageous for deep space missions, where a sufficient degree of contact with ground to perform the requisite analyses may not be possible.

The simulator of the present disclosure may be used pre-mission (e.g., planning of mission-specific operations) and post-flight (e.g., onboard or on ground to test new operations or operational workarounds). Post-flight may include during orbital operations or between or after robotic operations.

In some embodiments, the simulator may be used pre-mission to (i) generate control parameters and (ii) run simulations and tune parameters and steps. Pre-mission efforts may include free space robotics operations analysis, which may include rate limit verification for maneuvering, station attitude control system impact to robotics, and trajectory specific analysis. Pre-mission efforts may include contact robotics operations analysis, which may include visiting vehicle berthing, small payload installation and extraction with or without force moment accommodation (sensor for touch), and free flyer vehicle capture.

In some embodiments, the simulator may be used post-flight to (i) assess changes in operating characteristics, (ii) improve truth model simulation, and (iii) improve autonomous replanning capability and anomaly prevention and detection. Post-flight efforts may include free space robotics operations analysis, which may include assessing off-nominal changes in performance and characterization of nominal arm parameters. Post-flight efforts may include contact robotics operations analysis, which may include investigating jamming events during payload installation, assessing successful nominal installation or extraction for operations for load limit violations, and evaluating requirements for new robotic interfaces and examining success of robotically similar interfaces.

It should also be noted that, in some embodiments, the simulator of the present disclosure may be used to generate simulated training data for training a machine learning model for supporting operations of a robotic system. The machine learning model may be used to assist planning activities pre-flight or post-flight, and which may include nominal or off-nominal planning. for use in supporting pre-flight or post-flight activities.

While some embodiments of the present disclosure are described in the context of modeling or simulating contact dynamics in a robotic system, it should be noted that the simulation system, methods, and techniques described herein may be used to model other hard-to-model phenomena while preserving essential system behaviour. The systems and methods provide computationally inexpensive representations of more complex models, providing dimensionality reduction that may capture the most important dynamical characteristics of large, high-fidelity simulations and models of physical systems.

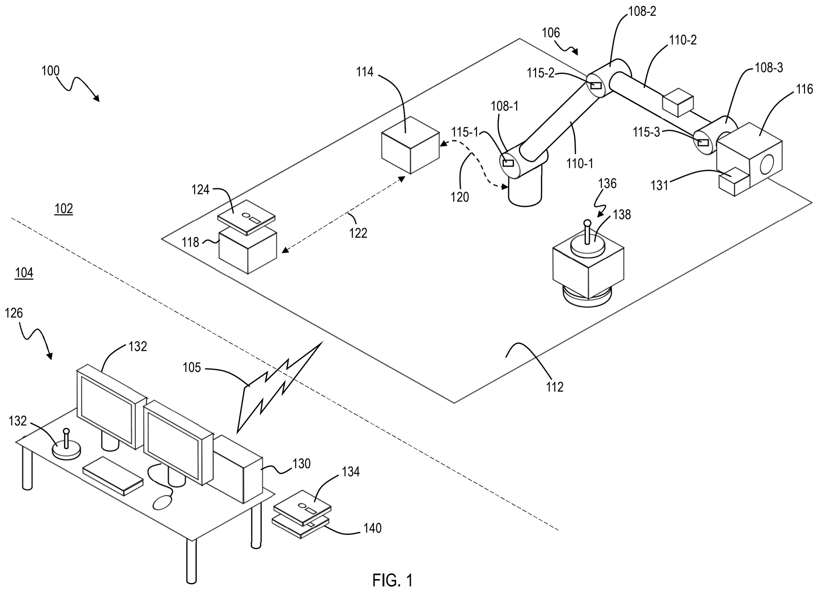

Referring now to Figure 1, shown therein is a robotic system 100, according to an embodiment.

The robotic system 100 is a space-based robotic system. The robotic system 100 is an example of a robotic system with which the simulation techniques of the present disclosure may be used. For example, the simulation techniques may be used to assess operational tasks performed by the robotic system 100 which involve non-compliant robotic payloads or capabilities beyond the design specification of the robotic system 100.

The system 100 includes a space segment 102 and a ground segment 104. The space segment 102 and the ground segment are in communication with each other via communication link 105.

The robotic system 100 includes a robotic arm 106. The robotic arm 106 may be a serial robotic manipulator. The robotic arm 106 may be a 6-degree-of-freedom (6-DOF) robotic arm. The robotic arm 106 may be a 7-DOF robotic arm. The robotic arm 106 includes a plurality of booms (or links/linkages) and joints for articulating the robotic arm 106. In an embodiment, the joints include three joints 108-1 to 108-3 (generically referred to as the joint 108, and collectively as the joints 108). In an embodiment, the booms include two booms 110-1, 110-2 (generically referred to as the boom 110, and collectively as the booms 110).

The robotic arm 106 is on a platform 112. The platform 112 may be a moving platform, such as on a spacecraft or rover, or a stationary platform. The platform may be a space station (e.g., International Space Station).

The robotic arm 106 is configured to perform one or more autonomous tasks (referred to simply as "tasks") based on instruction from an arm controller, such as robotic arm controller 114. Tasks may be a single action or composed of a sequence of robotic actions or subtasks. The type and nature of the tasks performed by the robotic arm 106 are not particularly limited. Example tasks or subtasks may include free space motion, contact operations, and non-contact operations. Contact operations may include tasks such as docking, berthing, or refueling. Non-contact operations may include tasks such as inspection or payload maneuvering. While performing certain tasks, the robotic arm 106 may physically interface with a robotic interface of a payload, such as the robotic interface 138 of the payload 136. The payload 136 may be a compliant robotic payload or a non-compliant robotic payload. Where the payload 136 is a non-compliant robotic payload, the robotic system 100 uses mission-specific simulation and analysis, such as described herein, to assess the operational task being performed. While performing tasks, sensors of the robotic arm 106, such as sensors 115-1 to 115-3 (generically referred to as the sensor 115, and collectively as the sensors 115) and camera 131, collect telemetry and visual imagery data.

The robotic arm 106 includes an end effector 116 coupled to a free end of the robotic arm 106. The end effector 116 may also be referred to as a tip of the robotic arm 106. The robotic arm 106 manipulates, moves, and positions the end effector 116. The end effector 116 may be an end effector that can be coupled and decoupled from the end of the robotic arm 106 (i.e. picked up and removed). The robotic arm 106 uses end effector 116 to physically interface with payload 136 through robotic interface 138. Robotic interface 138 may be, for example, a grapple fixture (including a grapple probe) attached to the payload 136 that is grappled by the end effector 116 in order to capture the probe and rigidize the payload 136 such that the robotic arm 106 can manipulate the payload 136.

The robotic system 100 includes a robotic arm controller 114. The arm controller 114 executes control software for controlling movement of the robotic arm 106 (e.g., by controlling joint rate and position of the joints 108). The arm controller 114 may implement a functional layer of the autonomous system including function level control software components. The arm controller 114 may be implemented at a single device or across a plurality of devices. For example, the arm controller 114 may be implemented particularly at a control device local to the robotic arm 106 and partially at an executive control device (e.g. flight computer 118) configured to determine, plan, and schedule robotic operations. Generally, the arm controller 114 controls movement (e.g., rotation) of the joints 108, thereby enabling controlled movement of the robotic arm 106 and ultimately of the end effector 116. The robotic arm 106 and the arm controller 114 are communicatively connected and the connection is represented as a hashed line 120 between the robotic arm 106 and the arm controller 114. The arm controller 114 may include computing components (e.g., processors, data storage) and other control hardware.

The robotic system 100 includes an onboard flight computer (or flight computer) 118. The flight computer 118 includes one or more processors for executing software components (or modules) and one or more data storage devices (e.g., computer memory) for story data. The flight computer 118 sends and receives data 122 from the arm controller 114.

The flight computer 118 includes executive control software 124. In some embodiments, the flight computer 118 may be configured to execute one or more reinforcement learning models, simulators, or anomaly detectors as described herein as part of the executive control software 124.

In some embodiments, the flight computer 118 may also include a script executor module as part of the executive control software 124. The script executor module executes task scripts corresponding to robotic tasks or operations to be performed by the robotic arm 106. The script executor module sends commands based on execution of the script.

The robotic system 100 further includes a robotic ground operator station 126 (or robotic workstation 126) located in the ground segment 104. The robotic workstation 126 communicates by an uplink/downlink system (represented by 105) via a network connection to send and receive data to and from the space segment 102.

The robotic workstation 126 includes one or more computer systems 130 including processors and memories storing processor executable instructions and one or more input/output devices 132 for enabling operator interaction with the computer system 130 and control of the space segment 102 components. For example, a display device of the input/output device 132 may display a user interface to the operator. The computer system of the ground segment 104 executes ground segment software 134 for performing the functions of the robotic workstation 126. The ground segment software 134 may include software modules for performing any one or more of reinforcement learning, RL model-based prediction, simulation based on an output of an RL model, and anomaly detection. The ground segment software 134 includes a user interface module for enabling an operator user to interact with the system 100 (e.g., through displaying data from the space segment 102 and receiving input on data to be sent to the space segment 102).

The robotic workstation 126 includes a simulator module 140 (also referred to as simulator 140). Generally, the simulator 140 is an approximator of dynamics of one or more dynamical systems that include the robotic arm 106. The dynamics may include, for example, contact dynamics (e.g., during a contact operation with payload 136), gearbox backlash, flexible body deformation, rigid-body kinematics, environmental perturbations (e.g., solar radiation pressure or orbital aerodynamic drag), or multi-body orbital mechanics. In the case of contact dynamics, the simulator module 140 approximates dynamics of the robotic arm 106 and the payload 134 (which are both dynamical systems). Generally, the simulator module 140 may be used to model dynamics of the robotic arm 106, including hard-to-model phenomena, while preserving essential system behavior.

In an embodiment, the simulator 140 is an approximator of contact dynamics between contact bodies. Contact dynamics include forces, moments, and kinematic changes when two physical bodies interact (such as, for example, the end effector 116 interacting with the payload 136). Contact bodies include the objects or surfaces in contact (such as, for example, the robotic arm 106 and the payload 136 (e.g., grapple fixture 138)). The simulator 140 may approximate the contact dynamics between the robotic arm 106 and the payload 136 during an operational task executed by the robotic arm 106 with respect to the payload 136.

Typically, the contact dynamics of the robotic arm 106 may be calculated by a contact dynamics toolkit if not for the simulator 140. Calculating the contact dynamics of the robotic arm 106 with the contact dynamics toolkit is typically very slow and can take weeks to months depending on the analysis. The simulator 140 is trained or configured to predict the contact dynamics of the robotic arm 106 with near-real-time speed, thereby obviating the need for the contact dynamics toolkit and greatly reducing the time required to determine contact dynamics.

The simulator 140 uses positions and velocities of contact bodies as input data and generates forces and moments of the contact bodies. The simulator 140 includes a simulator dynamics engine (such as a Space Station Portable Operations Training Simulator - SPOTS) and a dynamical downscaled model. The simulator dynamics engine uses the forces and moments of the contact bodies to determine the positions and velocities of the contact bodies and provides the positions and velocities to the downscaled model. The downscaled model uses the positions and velocities to generate the forces and moments.

The simulator 140 predicts contact dynamics during contact operations performed by the robotic arm 106, such as flight capture missions and berthing. The simulator 140 may be implemented on the flight computer 118.

The simulator 140 uses a contact dynamics estimation algorithm. The algorithm is machine learning-based (e.g., one or more machine learning models or algorithms). In general, it may be desired that the simulator 140 use an explainable AI or explainable machine learning technique. This may be particularly important in space-based systems and operations, where safety and verifiability are often viewed as critical.

The simulator 140 may be trained using data from simulated telemetry and past flight telemetry, using flight software telemetry input, and total dynamic external force (effectively the total contact force) as output. The simulated telemetry may include data from a high-fidelity simulator or digital twins as a dual input. The dual input of the simulated telemetry may better ensure the simulator 140 generalizes to real scenarios while leveraging large synthetic datasets. The simulator 140 may be trained according to a traditional artificial intelligence (AI) model training process. The simulator 140 may be trained according to a supervised training method. The training method may include collecting labelled examples of input states (such as positions and velocities of the end effector 116) and expected forces and moments from simulated telemetry or flight telemetry. Where the simulator 140 is trained partially or completely using simulated telemetry, the simulated telemetry may be generated using any suitable simulation technique. In particular embodiments, the simulated training telemetry may be generated by a digital twins system or hardware emulation system.

In an embodiment, the simulator 140 comprises a recurrent neural network.

In an embodiment, the simulator 140 comprises a general deep learning model. General deep learning models may include neural networks and multi-layer perceptrons (MLP). The general neural network may be trained on past flight or simulated telemetry using a supervised learning process. The term "general deep learning model" as used herein refers to a traditional deep learning model trained solely from data without explicit incorporation of physics-based constraints (in contrast to physics-informed neural networks, described herein).

In an embodiment, the simulator 140 comprises a long short-term memory ("LSTM") network.

In an embodiment, the simulator 140 comprises a physics-informed neural network (PINN).

The PINN embeds known physical laws into its loss function. The known physical laws may include dynamics equations and/or conservation principles. This guiding framework helps the PINN achieve better generalization with less data and ensures that the predicted sensors outputs comply with underlying physical principles. A PINN is a special class of artificial neural network (which is a series of mathematical functions with weights that are optimized from training data) that is trained and optimized with governing physical equations.

The PINN incorporates physical laws of a dynamical system (e.g., governing the dynamics of a robotic arm 106) described by one or more differential equations into its loss function to guide the learning process toward solutions that are more consistent with the underlying physics. This may include incorporating in the PINN the robotic arm's dynamics governed by classical mechanics equations, such as Euler-Lagrange equations or Newton-Euler equations. This may include incorporating equations of motion, gravitational effects, and mechanical link constraints.

The PINN is a type of universal function approximator that embeds knowledge of any physical laws that govern a given dataset in the learning process and can be described by differential equations. The PINN uses data-driven supervised neural networks to learn the model and also uses physics equations that are given to the model to encourage consistency with the known physics of the system. The PINN may advantageously be a more robust model that can be generated with less data. The PINN is a neural network that is trained to solve supervised learning tasks while respecting any given laws of physics described by general nonlinear partial differential equations. The prior knowledge of general physical laws acts in the training of the neural network as a regularization agent that limits the space of admissible solutions, increasing the generalizability of the function approximation.

In an embodiment, the PINN is trained to ensure its predictions of forces and torques align with known robotic arm dynamics. For instance, the PINN loss might penalize deviations from Lagrangian or Newton-Euler derived motions, ensuring the outputs of the simulator 140 reflect physically plausible states. It should be noted that Euler-Lagrange is a specific equation that may be used in some embodiments. In other embodiments, other equations may be used (e.g., Hamiltonians have differential equations).

The PINN may be generated by deriving one or more physics equations (e.g., from Newtonian or Lagrangian mechanics) to be incorporated into the neural network, identifying training data (i.e., past flight or simulated telemetry), selecting a neural network architecture, building a loss function, and then executing a standard neural network training process using the established inputs to obtain the trained PINN.

For space robotics, the differential equations governing the dynamics of the robotic arm 106 may be the standard equations of motion derived from formulations described above. Suitable neural network architecture for the PINN may include fully connected feed-forward networks, where hidden layers approximate solutions to the dynamics equations. Networks architectures may also incorporate long short-term (LSTM) layers to handle time-dependent sequences for tasks like predicting joint torque under varying load conditions.

In a particular embodiment, the PINN uses the principle of least action which yields the Euler-Lagrange equation for deriving the governing equations. Once a dynamical system of interest is known (e.g., a 7DOF robotic arm) and its Lagrangian is defined, the set of governing equations are then derived.

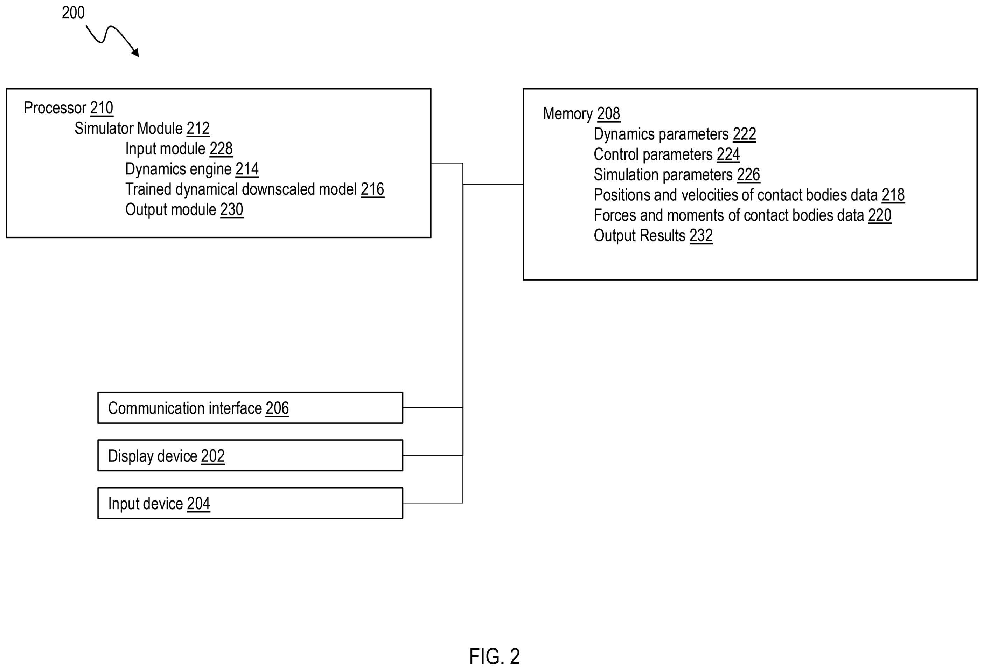

Referring now to Figure 2, shown there is a computer system 200 for simulation of contact dynamics of a robotic system, according to an embodiment.

In an embodiment, the computer system 200 may be implemented using the flight computer 118 and/or the robotic workstation 126 of Figure 1. It should be noted that, in variations, software modules and components of the system 200 may be implemented or executed at a single computing device or across multiple computing devices (e.g. networked computer devices).

The system 200 includes a display device 202 for displaying data generated by the system 200. The display device 202 may be located at a user device of the system 200, such as the robotic workstation 126 of Figure 1.

The system 200 includes an input device 204 for providing input data to the system 200 by a user, such as through a graphical user interface. The input device 204 may include a pointing device (e.g., a mouse), a keypad, or the like.

The system 200 includes a communication interface 206 for transmitting and receiving data. The communication interface 206 may include a network interface. The communication interface 206 may implement the uplink/downlink system 105 of Figure 1.

The system 200 includes a memory 208 and a processor 210 in communication with the memory 208.

The processor 210 includes a simulator module 212, an input module 228, and an output module 230. The simulator module 212 may be implemented by the simulator 140 of Figure 1.

The input module 228 receives input data that is provided to the simulator module 212. In variations, the input module 228 may be configured to receive input data from a human user (e.g.. via a graphical user interface) or from another system or computer program/software.

The output module 228 outputs results of the simulation executed by the simulator module 212. In variations, the output module 228 may output simulation results for display to a human user (e.g., via a graphical user interface) or to another system or computer program/software.

The simulator module 212 is configured to simulate contact dynamics of contact bodies. The simulator module 212 uses reduced order model contact dynamics.

The contact bodies may be the robotic arm 106 and the payload 136 of Figure 1.

The simulator module 212 includes an input module 228, a dynamics engine 214, a trained dynamical model 216, and an output module 230. The dynamical model 216 may be considered or referred to as a "downscaled" or "reduced order" model.

The dynamics engine 214 is a multi-body simulator that calculates, for example, new positions and velocities of contact bodies based on forces and moments of the contact bodies, forming a feedback loop with the dynamical model 216. The dynamics engine 214 handles fundamental kinematics and standard flexible-body updates. The dynamics engine 214 integrates forces into motion, enabling the dynamical model 216 to determine contact-specific forces/moments.

The simulator module 212 receives input data via the input module 228. The input data includes dynamics parameters 222, control parameters 224, and simulation parameters 226. The parameters 222, 224, 226 are stored in the memory 208. The dynamics parameters 222 may include mass, inertia, link lengths, center of gravity, or friction constants. The control parameters 224 may include joint torque commands, velocity profiles, or PID gains. The simulation parameters 226 may include time step size, duration, initial conditions, or environmental factors like gravity. Each of the parameters 222, 224, 226 provides for meaningful, physically constant simulation.

The parameters 222, 224, 226 may come from a combination of user inputs (such as mission specialists specifying scenario details through the input device 204, for example), known specifications of the robotic arm 106, and real flight telemetry. Some of the parameters 222, 224, 226 may be auto-generated by mission planning tools.

In variations, the input module 228 may be configured to receive the parameters 222, 224, 226 from a human user (e.g. via a graphical user interface) or from another system or computer program/software (e.g., autonomously).

The dynamics parameters 222, control parameters 224, and simulation parameters 226 are provided as input to the dynamics engine 214.

The dynamics engine 214 receives the parameters 222, 224, 226 as input and generates positions and velocities of the contact bodies 218. In various embodiments, the positions and velocities 218 may include positions alone, velocities alone, or both positions and velocities. The positions and velocities of the contact bodies 218 are stored in the memory 208. The dynamics engine 214 may be a generalized multi-body simulator. The dynamic engine 214 may support multiple robotic configurations with a variety of topologies including open-loop, closed-loop, and tree.

The positions and velocities of the contact bodies 218 are provided as input to the dynamical model 216.

The dynamical model 216 receives the positions and velocities data 218 as input and generates contact forces and moments data 220. In some embodiments, forces and moments data 220 may include forces data only, moments data only, or a combination of forces data and moments data. The contact forces and moments 220 are stored in the memory 208. The dynamical model 216 may be a machine learning model trained to learn overall contact dynamics across all sub-bodies, resolved at the inboard frame. The inboard frame is a reference coordinate frame from which positions and velocities are measured. For example, the inboard frame may be located at a joint or base link of the robotic arm 106. The inboard frame sets the reference for how forces and motions are calculated.

The contact forces and moments data 220 are provided as input to the dynamics engine 214. The dynamics engine 214 uses the contact forces and moments data 220 to update motion equations used by the dynamics engine 214 and generate new positions and velocities data 218 in each simulation timestep of the simulator module 212. The dynamics engine 214 closes the feedback loop between the dynamics engine 214 and the dynamical model 216, wherein the dynamical model 216 predicts contact forces and moments, and the dynamics engine 214 integrates the contact forces and moments to get the next state of the simulation.

The dynamics engine 214 processes the forces and moments data 220 and generates simulation output results 232. Simulation output results 232 may include time-series data of positions, velocities, or contact forces and moments across each simulation step. The time series data may include any final states or stability metrics. The final states may include an overall configuration of the dynamical systems once the simulation finishes or reaches a specified end time. Typically, the final states include kinematic or dynamic parameters needed to fully describe the robotic arm 106 and the payload 136 at the last time step, such as joint angles, linear velocities, rotational velocities, and other relevant metrics. The simulation output results 232 may further include collision flags, force exceedance alerts, or recommended control adjustments.

In an embodiment, the simulator module 214 operates as follows: (1) the dynamics engine 214 calculates motion based on prior forces and moments and generates updated positions and velocities; (2) the updated positions and velocities are fed to the dynamical model 216, which predicts new contact forces and moments; and (3) the dynamics engine 214 then integrates the new contact forces and moments to get the next state of the simulation.

In some embodiments, the computer system 200 further includes a mission planner module executed by the processor 210 and a mission planning database stored in the memory 208. The output results 232 of the simulation conducted by the simulator module 212 includes one or more mission-specific commands or control parameters. Once the results of the simulation are confirmed, the processor 210 updates the mission planning database with the output results 232. This enables the mission planner module to generate appropriate flight products for inclusion in a mission plan. The flight products may include any software upload or command script that may be executed by the flight computer (such as the flight computer 118), which may include updated control parameters, task scripts, or onboard autonomy rules. The flight products may be made available for use in future mission planning activities by the mission planner module. In an embodiment, the mission planner module may be an automated mission planner module that functions as described in US Provisional Patent Application 63/708,376, which is incorporated by reference herein in its entirety.

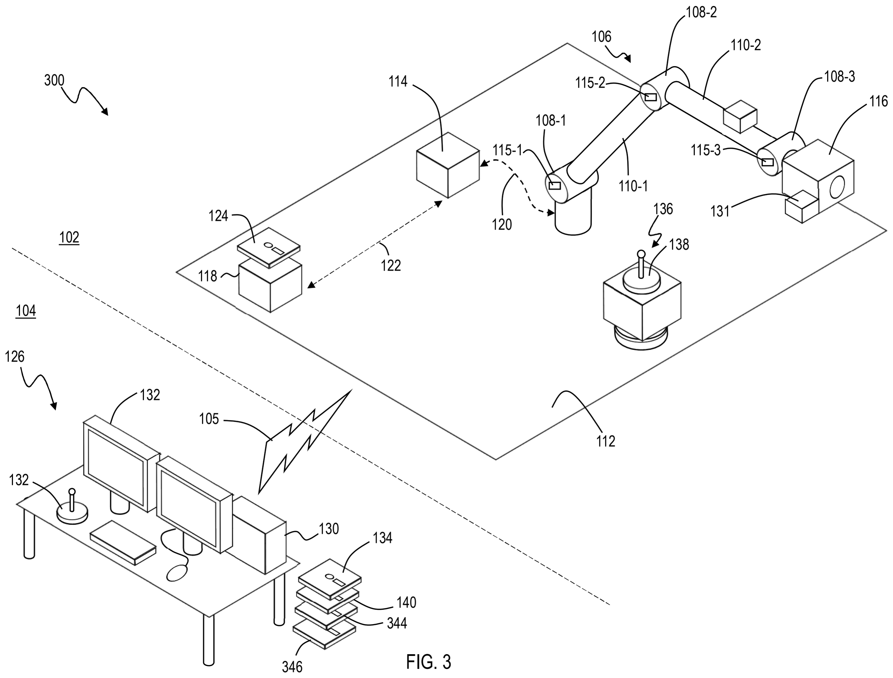

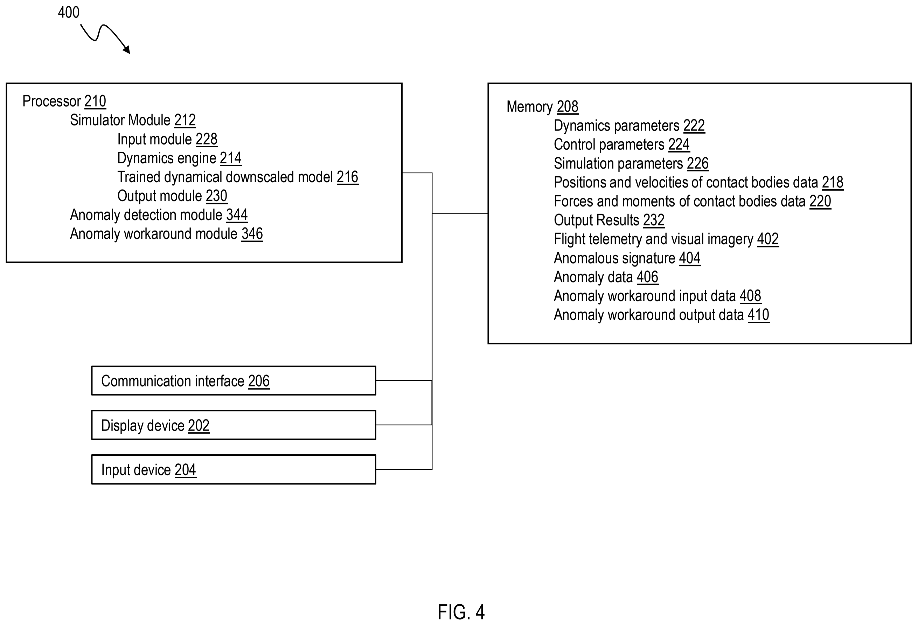

Referring now to Figures 3 and 4, shown therein is a robotic system 300 and computer system 400 servicing the robotic system 300, according to embodiments.

The robotic system 300 is an embodiment of the robotic system 100 of Figure 1 and the computer system 400 is an embodiment of the computer system 200 of Figure 2. Like references denote like components with respect to Figures 1 and 2. Certain components present in Figure 3 with corresponding components in Figure 1 may not be described in detail. It is understood that such components perform the same or similar function as the corresponding component in Figure 1.

The system 300 further includes an anomaly detection software module 344. In the system 300, the anomaly detection module 344 is implemented in the ground segment 104 at the computer system 130 of the robotic workstation 126. In other embodiments, the anomaly detection module 344 may be implemented in the space segment 102, such as on the flight computer 118. Similarly, in the system 300, the simulator 140 is implemented at the computer system 130 of the robotic workstation 126. In other embodiments, the simulator 140 may be implemented in the space segment 102, such as on the flight computer 118 (e.g., along with anomaly detection module 344).

The anomaly detection module 344 may execute an anomaly detection algorithm, such as described in US Provisional Patent Application No. 63/710,885 or US Provisional Patent Application No. 63/736,716, which are incorporated by reference herein in their entirety. The anomaly detection module 344 analyzes telemetry and/or visual imagery data collected by the robotic system 300 during the execution of a robotic task by the robotic arm 106 to detect or predict anomalous or off-nominal behaviour of the robotic arm 106 or its subsystems.

The system 300 further includes an anomaly workaround software module 346. In the system 300, the anomaly workaround module 346 is implemented in the ground segment 104 at the computer system 130 of the robotic workstation 126. In other embodiments, the anomaly workaround module 346 may be implemented in the space segment 102, such as on the flight computer 118.

The anomaly workaround module 346 is used in response to an anomaly detected by anomaly detection module 344 to identify a workaround for an operational task to be performed by the robotic arm 106. When an on-orbit anomaly is diagnosed and identified (e.g., by the anomaly detection module 344), operational workarounds often need to be determined by instantiating the issue into a simulation or test environment (e.g., by the simulator 140) and formulating techniques to resolve or accommodate the problem in order to continue safe and effective operations. The identified workarounds can allow for mission success criteria to be achieved, while satisfying safety constraints (e.g., loads, keep-out zones, proximity to structure).

In an embodiment, the anomaly workaround module 346 includes a machine learning model developed using reinforcement learning ("reinforcement learning model"). The reinforcement learning model may be trained and function as described in U.S. Provisional Patent Application No. 63/780,755, filed March 31, 2025, which is incorporated herein by reference in its entirety.

Referring now to Figure 4, the processor 210 of the computer system 400 further includes the anomaly detection module 344 and the anomaly workaround module 346.

As described above, sensors of the robotic system 300 (e.g., the sensors 115 and the camera 131) collect telemetry and visual imagery data 402 ("telemetry 402") during execution of the robotic task by the robotic arm 106. The telemetry 402 is fed automatically to the anomaly detection module 344 for analysis. The telemetry 402 may be streamed in real-time or periodically batched into the input pipeline of the anomaly detection module 344. The anomaly detection module 344 may process the telemetry 402 by a machine learning model or rule-based checks. The anomaly detection module 344 may further flag anomalies when patterns of the telemetry 402 deviate from normal.

The anomaly detection module 344 is configured to detect an anomalous signature 404 in the processed telemetry 402 and identify an anomaly, such as by outputting an anomaly flag. The data outputted by the anomaly detection module 344 describing the detected anomaly may be referred to as anomaly data 406. The anomaly data 406 may include, for example, an anomaly flag indicating or identifying a type or category of anomaly, identifying information about the subsystem showing the anomaly, and the anomalous signature 404.

The anomaly data 406 is used to configure anomaly workaround input data 408 to the anomaly workaround module 346. The anomaly data 406 may be packaged into a format suitable for the workaround module 346 to generate the input data 408. This format may include, for example, state vectors or error codes. Packaging the anomaly data 406 into a suitable format may include filtering or summarizing the data 406 so that the module 346 or other fallback method can adapt the script. The fallback method may include a manual script to bypass advanced algorithms, or a simplified step-by-step procedure. The anomaly workaround module 346 receives the input data 408 and outputs anomaly workaround output data 410. The output data 410 specifies a workaround for at least one operational task to be performed by the robotic arm 106. The output data 410 may include, for example, control parameters for the robotic arm 106 when performing the task.

The anomaly workaround output data 410 is then provided as input to the simulator module 212. This may be done automatically or through user interaction. The simulator module 212 is then used to simulate results of task execution using the parameters identified through the anomaly workaround module 346. In this way, the simulator module 212 may be used to test potential workarounds for anomalies detected on orbit or in space. This may greatly increase the speed with which safe and effective workarounds can be identified.

In some embodiments, the anomaly workaround module 346 may not be present and the simulator module 212 is used or invoked based on the anomaly data 406. Such an embodiment may include, for example, manual review of anomaly data 406 in a user interface and subsequent configuration of the inputs to the simulator module 212 based on the anomaly data 406. Upon confirmation of the simulation results, the workaround may be encoded into a flight product and executed by the flight computer 118.

In embodiments where the anomaly workaround module 346 is not present, an operator or automated planning tool may manually adjust parameters (such as speed reductions, different approach angles) and re-run the simulator module 212 to confirm whether the adjustments mitigate the anomaly. A workaround may include any adjustment to an existing robotic task script that attempts to overcome or mitigate the anomaly or its effects. Accordingly, a user or a separate heuristic may define "candidate workaround" parameters, provide the parameters to the simulator module 212, and check the output results 232.

It should further be noted that the anomaly workaround module 346 may, in some embodiments, be configured to perform nominal planning (i.e., as opposed to off-nominal planning, or planning in response to an anomaly).

In some embodiments, estimated telemetry is used by the simulator 140 of Figure 1 executed by a computer system. The simulator 140 predicts contact dynamics during contact operations performed by the robotic arm 106, such as flight capture missions and berthing.

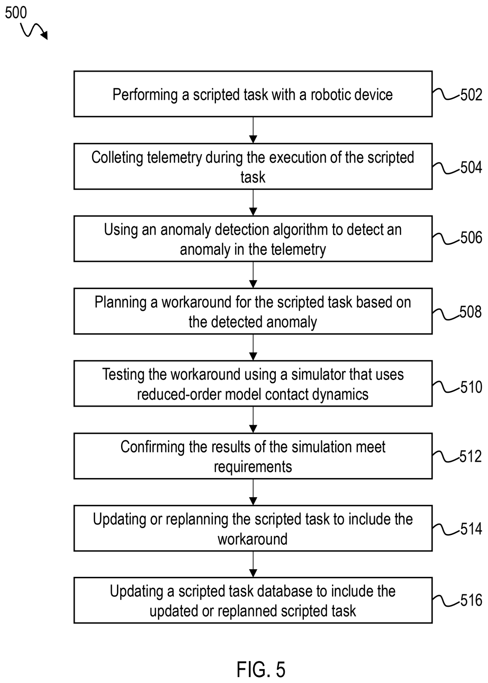

Referring now to Figure 5, shown therein is a method 500 for performing simulation of robotic operations by a robotic system, according to an embodiment. The method 500 may be implemented by any of the systems of Figures 1-4. In variations, the method 500 may be performed entirely in the ground segment 104, entirely in the space segment 102, or in some combination of the ground and space segments.

At 502, the method 500 includes performing a scripted task with a robotic device. The robotic device may be for example, the robotic arm 106 of Figure 1 or any other robotic device configured to perform autonomous tasks (e.g., a rover).

At 504, the method 500 includes collecting telemetry during the execution of the scripted task by the robotic device. The telemetry is collected by one or more sensors or systems on or around the robotic device.

At 506, the method 500 includes using an anomaly detection algorithm to detect an anomaly in the telemetry. The anomaly indicates off-nominal behaviour in the robotic device. The anomaly detection algorithm may be the anomaly detection module 344 of Figures 3-4.

At 508, the method 500 includes planning a workaround for the scripted task based on the detected anomaly. The workaround may be planned, for example, using the anomaly workaround module 346 of Figures 3-4. The workaround may include, for example, new joint trajectories, adjusted velocity profiles, changed approach angles, or altered control gains, of the robotic arm 106. The workaround may include anything that modifies the original plan of the robotic arm 106 to avoid or mitigate the anomaly.

At 510, the method 500 includes testing the workaround using a simulator that uses reduced-order contact dynamics. The simulator may use a neural network. The neural network may be a physics-informed neural network, such as described herein. The simulator may be the simulator 140 of Figures 1 and 3 or simulator module 212 of Figures 2 and 4.

At 512, the method 500 includes confirming the results of the simulation meet requirements. The results of the simulation may be confirmed by comparing the results to thresholds for forces, torques, or trajectory constraints of the robotic arm 106 (which comparison may be done manually by a user through a GUI or automatically by software). The results of the simulation may further be confirmed by visual inspection of the results, or by automatic checking by the system to confirm if key safety and performance criteria are met. The simulation results may be confirmed by a user evaluating an output of the simulation through a user interface. The simulation results may be confirmed automatically through reference to one or more performance thresholds (indicating acceptable results).

At 514, the method 500 includes updating or replanning the scripted task to include the workaround. This may be performed manually by a user through a user interface or automatically through an automated planning software module.

At 516, the method 500 includes updating a scripted task database to include the updated or replanned scripted task.

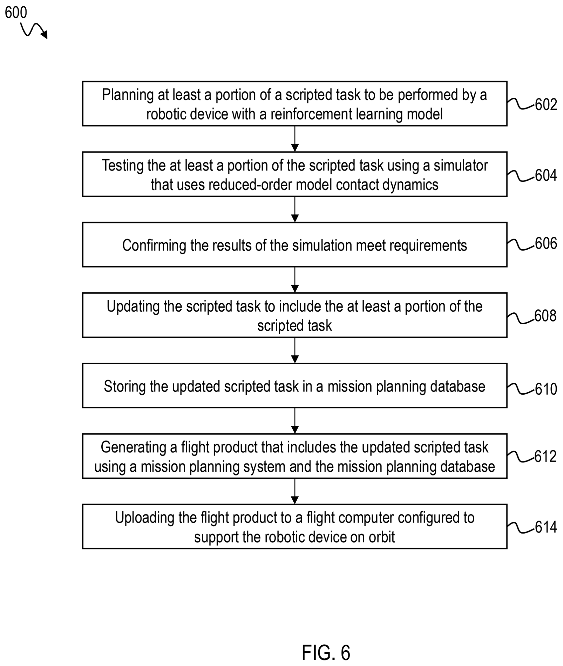

Referring now to Figure 6, shown therein is a method 600 for performing simulation of robotic operations, according to an embodiment. The method 600 may be implemented by any of the systems of Figures 1-4. In variations, the method 600 may be performed entirely in the ground segment 104, entirely in the space segment 102, or in some combination of the ground and space segments.

At 602, the method 600 includes planning at least a portion of a scripted task to be performed by a robotic device (such as the robotic device in method 500) with a reinforcement learning model.

At 604, the method 600 includes testing the at least a portion of the scripted task using a simulator that uses reduced-order model contact dynamics. The simulator may be the simulator of method 500.

At 606, the method 600 includes confirming the results of the simulation meet requirements. This may be performed as in act 512 of Figure 5.

At 608, the method 600 includes updating the scripted task to include the at least a portion of the scripted task. This may be performed manually by a user or automatically through software.

At 610, the method 600 includes storing the updated scripted task in a mission planning database.

At 612, the method 600 includes generating a flight product to be executed by a flight computer in communication with the robotic device. The flight product includes the updated scripted task. The flight product is generated using a mission planning system (e.g., software application) and the mission planning database.

At 614, the method 600 includes uploading the flight product to the flight computer. The flight computer is configured to support operation of the robotic device when the robotic device is in use (e.g., in space).

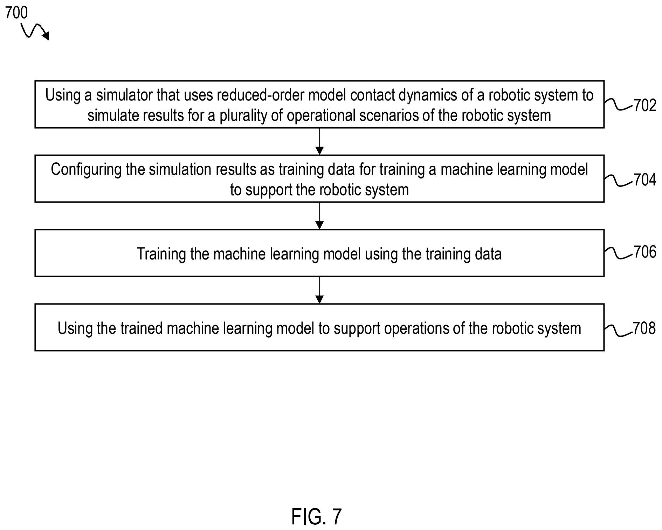

Referring now to Figure 7, shown therein is a method 700 of performing simulation of robotic operations, according to an embodiment. The method 700 may be implemented by any of the systems of Figures 1-4. In variations, the method 700 may be performed entirely in the ground segment 104, entirely in the space segment 102, or in some combination of the ground and space segments.

At 702, the method 700 includes using a simulator that uses reduced-order model contact dynamics of a robotic system or device to simulate results for a plurality of operational scenarios of the robotic system. The robotic system may be the robotic device of method 500. The simulator may be the simulator of method 500.

At 704, the method 700 includes configuring the simulation results as training data for training a machine learning model that is to be used to support the robotic system. In an embodiment, the machine learning model is a virtual sensor used to collect telemetry or other sensor data during performance of tasks by the robotic device. In an embodiment, the machine learning model is a reinforcement learning model used for planning robotic operations (e.g., nominal or off-nominal). In an embodiment, the machine learning model is a physics-informed neural network.

At 706, the method 700 includes training the machine learning model using the training data. Training may include any suitable training process for a machine learning model.

At 708, the method 700 includes using the trained machine learning model to support operations of the robotic system.

While the above description provides examples of one or more apparatus, methods, or systems, it will be appreciated that other apparatus, methods, or systems may be within the scope of the claims as interpreted by one of skill in the art.

## Claims

1. A computer system for modeling dynamics of a space robotic system including a robotic device, the computer system comprising:
a computer memory and at least one processor in communication with the computer memory;
wherein the at least one processor is configured to execute a simulator module for simulating dynamics of at least one dynamical system including the robotic device at a series of simulation timesteps during an operation executed by the robotic device;
wherein the simulator module comprises a dynamics engine module and a first machine learning model that operate in a feedback loop;
wherein for each timestep in the series of simulation timesteps the simulator module determines (i) position or velocity values of the at least one dynamical system and (ii) force or moment values of the at least one dynamical system;
wherein for a first timestep a set of initial conditions are provided to the dynamics engine module to calculate the position or velocity values;
wherein the force or moment values are predicted by the first machine learning model based on the position or velocity values from the same timestep;
wherein after the first timestep, the position or velocity values are calculated by the dynamics engine module based on a motion equation that is updated using the force or moment values from the immediately preceding timestep; and wherein the simulator module determines the position or velocity values and the force or moment values until a last timestep.

2. The system of claim 1, wherein the simulator module is implemented on a flight computer that operates onboard the space robotic system when in flight.

3. The system of claim 1, wherein the first machine learning model comprises a physics-informed neural network (PINN).

4. The system of claim 1, wherein the simulator module outputs results data including time series data of positions, velocities, or contact forces or moments across each timestep of the series of simulation timesteps.

5. The system of claim 4, wherein the results data is used to generate training data for training a second machine learning model to support the robotic device during operations.

6. The system of claim 5, wherein the second machine learning model is a virtual sensor used to collect telemetry or other sensor data during performance of tasks by the robotic device or a reinforcement learning model used for planning robotic operations.

7. The system of claim 1, wherein the simulator module is used to test a potential workaround for the robotic device in response to an anomaly detected in telemetry collected during performance of the operation.

8. The system of claim 1, wherein the simulator module is used to test a script to be executed by the robotic device during the operation prior to the script being incorporated into a flight product and uploaded to the robotic device.

9. A method of simulating dynamics of a space robotic system, the method comprising:
configuring a simulator module to run a simulation that simulates dynamics of at least one dynamical system in the space robotic system at a series of simulation timesteps during an operation executed by the space robotic system, the simulator module including a dynamics engine module and a first machine learning model;
executing the simulation using the simulator module, wherein the simulator module implements a feedback loop in which the first machine learning model predicts force or moment values on the at least one dynamical system for a current timestep in the series of simulation timesteps using position or velocity values calculated by the dynamics engine for the current timestep as input and the dynamics engine calculates position or velocity values of the at least one dynamical system for the current timestep using a motion equation that is updated using force or moment values that were predicted by the first machine learning model for the previous timestep.

10. The method of claim 9, further comprising using results outputted by the simulator to generate training data for training a second machine learning model for supporting operations of the robotic system and training the machine learning model with the training data.

11. The system of claim 1, wherein the at least one dynamical system includes a payload on which the robotic device acts, wherein the operation is a contact operation between the robotic device and the payload.

12. The system of claim 1, wherein the simulator module simulates contact dynamics between the robotic device and a payload or flexible body dynamics of the robotic device.

13. The method of claim 9, wherein the simulator module simulates contact dynamics between a first dynamical system and a second dynamical system or flexible body dynamics of the at least one dynamical system.

14. The system of claim 1, wherein the first machine learning model is a neural network module.

15. The method of claim 9, wherein the first machine learning model is a neural network module.
